(19) Europäisches Patentamt
European Patent Office
Office européen des brevets

(11) **EP 4 252 101 B1**

(12) **FASCICULE DE BREVET EUROPEEN**

(45) Date de publication et mention
de la délivrance du brevet:
**20.05.2026 Bulletin 2026/21**

(21) Numéro de dépôt: **21823981.2**

(22) Date de dépôt: **24.11.2021**

(51) Classification Internationale des Brevets (IPC):
*G06F 3/01* *(2006.01)*    *G06F 3/043* *(2006.01)*
*G01S 15/00* *(2020.01)*    *G01S 15/66* *(2006.01)*
*G01S 15/87* *(2006.01)*

(52) Classification Coopérative des Brevets (CPC):
**G06F 3/017; G01S 15/66; G01S 15/876;
G06F 3/043;** G06F 2203/04108

(86) Numéro de dépôt international:
**PCT/FR2021/052080**

(87) Numéro de publication internationale:
**WO 2022/112712 (02.06.2022 Gazette 2022/22)**

(54) **DISPOSITIF DE DÉTECTION D'ÉLÉMENT SANS CONTACT**

VORRICHTUNG ZUR KONTAKTLOSEN ELEMENTDETEKTION

CONTACTLESS ELEMENT DETECTION DEVICE

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR

(30) Priorité: **26.11.2020 FR 2012214**

(43) Date de publication de la demande:
**04.10.2023 Bulletin 2023/40**

(73) Titulaire: **Commissariat à l'Energie Atomique et
aux Energies
Alternatives
75015 Paris (FR)**

(72) Inventeurs:
• **OREFICE, Pierre-Henri
91191 GIF SUR YVETTE CEDEX (FR)**
• **HUDIN, Charles
91191 GIF SUR YVETTE CEDEX (FR)**

(74) Mandataire: **Santarelli
Tour Trinity
1 bis Place de la Défense
92400 Courbevoie (FR)**

(56) Documents cités:
**EP-B1- 2 271 951     WO-A1-2011/048433**

• **PANTER LUCIE ET AL: "Sparse Actuator Array
Combined with Inverse Filter for Multitouch
Vibrotactile Stimulation", 2019 IEEE WORLD
HAPTICS CONFERENCE (WHC), IEEE, 9 July
2019 (2019-07-09), pages 19 - 24, XP033608876,
[retrieved on 20190826], DOI: 10.1109/
WHC.2019.8816107**
• **ETAIX NICOLAS ET AL: "Acoustic imaging
device with one transducer", THE JOURNAL OF
THE ACOUSTICAL SOCIETY OF AMERICA,
AMERICAN INSTITUTE OF PHYSICS, 2
HUNTINGTON QUADRANGLE, MELVILLE, NY
11747, vol. 131, no. 5, 1 May 2012 (2012-05-01),
pages EL395 - EL399, XP012160225, ISSN:
0001-4966, [retrieved on 20120413], DOI: 10.1121/
1.3699533**
• **LE BAS P-Y ET AL: "Damage imaging in a
laminated composite plate using an air-coupled
time reversal mirror", APPLIED PHYSICS
LETTERS, AMERICAN INSTITUTE OF PHYSICS,
2 HUNTINGTON QUADRANGLE, MELVILLE, NY
11747, vol. 107, no. 18, 2 November 2015
(2015-11-02), XP012201999, ISSN: 0003-6951,
[retrieved on 19010101], DOI: 10.1063/1.4935210**

- **TE-I CHIU ET AL: "Implementation of ultrasonic touchless interactive panel using the polymer-based CMUT array", SENSORS, 2009 IEEE, IEEE, PISCATAWAY, NJ, USA, 25 October 2009 (2009-10-25), pages 625 - 630, XP031618733, ISBN: 978-1-4244-4548-6**

## Description

## DOMAINE TECHNIQUE ET ART ANTÉRIEUR

L'invention concerne le domaine de la détection et de l'interaction à distance, sans contact, avec un ou plusieurs éléments. L'invention concerne plus particulièrement un dispositif permettant à un ou plusieurs éléments d'interagir avec ce dispositif, sans besoin de contact entre le dispositif et le ou les éléments, ainsi qu'un procédé de commande d'un tel dispositif.

Un dispositif de détection d'élément sans contact permet de déterminer ou caractériser la présence, la position ou encore le mouvement d'un ou plusieurs éléments, par exemple des doigts ou des mains d'un ou plusieurs utilisateurs, se trouvant à une certaine distance du dispositif. A partir de la détection réalisée, une interaction devient alors possible entre le ou les éléments détectés et le dispositif.

Il existe plusieurs technologies pour réaliser un tel dispositif.

Il est par exemple possible de réaliser un dispositif de détection d'élément sans contact en utilisant le principe d'une capture optique, faisant appel à une ou plusieurs caméras, lasers ou capteurs infrarouges. Toutefois, un tel dispositif est très sensible aux conditions optiques de l'environnement dans lequel il est utilisé. De plus, lorsqu'un tel dispositif est utilisé pour que l'utilisateur puisse interagir avec des objets 3D virtuels, la puissance de calcul nécessaire au fonctionnement du dispositif est très importante en raison de l'analyse des images capturées devant être réalisée. En outre, utiliser des lasers pour réaliser la capture optique est une solution onéreuse. Enfin, utiliser des capteurs infrarouges pour réaliser la capture optique présente également plusieurs inconvénients : encombrement important, une zone de perception faible, besoin d'un grand nombre de capteurs pour avoir une représentation suffisante de la zone observée. Des problèmes d'atteinte à la vie privée peuvent également se poser avec un tel dispositif du fait que la capture optique réalise une acquisition de tout ce qui se trouve autour du ou des éléments à détecter, comme par exemple le visage de l'utilisateur.

Il est également possible de réaliser un dispositif de détection d'élément sans contact en utilisant des radars miniatures. Les performances obtenues ne sont toutefois pas satisfaisantes, surtout si l'objet à détecter n'est pas métallique (comme par exemple une main ou un doigt).

Des dispositifs de détection d'élément sans contact utilisant des ondes wifi, ou des ondes électromagnétiques plus courtes, ont également été proposés. Toutefois, ces solutions requièrent des composants externes complexes risquant de saturer le réseau de communication avec lequel le dispositif communique.

Il a également été proposé de réaliser des dispositifs de détection d'élément sans contact en utilisant des matrices capacitives. Ces matrices sont toutefois peu performantes au-delà de quelques centimètres de distance entre la matrice et le ou les éléments à détecter, et peuvent être perturbées par des champs électriques environnants.

Des techniques de détection et d'interaction sans contact mises en œuvre en utilisant les microphones et haut-parleurs de téléphones mobiles, ou smartphones, ont également été proposées. Certaines de ces techniques réalisent une détection de gestes en utilisant des mesures de décalages fréquentiels et de perturbations de phase induits par un mouvement sur des ondes acoustiques émises par le ou les microphones du téléphone. Un apprentissage préalable permet d'associer différents gestes aux perturbations induites par les gestes réalisés par l'utilisateur sur les ondes acoustiques émises. Toutefois, ces techniques ne permettent pas de réaliser une localisation précise du ou des éléments à détecter s'ils sont immobiles, et donc ne permettent pas de réaliser par exemple une détection de manipulation d'objets 3D virtuels ou de déplacement d'un curseur virtuel par exemple. En outre, les gestes détectés doivent nécessairement être prédéfinis par le fabricant du dispositif. D'autres techniques permettent de suivre le déplacement d'un élément à détecter et de localiser cet élément dans l'espace par triangulation, suivi de temps de vol, de déphasage ou de réponse impulsionnelle. Les mesures réalisées sont toutefois peu précises et la reconstruction de trajectoire doit être généralement corrigée grâce à l'effet Doppler ou le suivi de changement de phase qui permettent de déterminer le sens, la vitesse du mouvement et la distance parcourue. Ces techniques n'améliorent pas la détection d'interaction quasi-statique (c'est-à-dire avec un mouvement de faible amplitude), rendant ces mouvements difficilement mesurables, et ne permettent pas de faire la distinction entre plusieurs éléments détectés simultanément tels que plusieurs doigts d'un utilisateur.

Par rapport aux systèmes précédemment énumérés, la technologie de détection à distance par ultrasons présente de nombreux avantages: compacité des composants utilisés, insensibilité aux conditions optiques d'utilisation, possibilité de fonctionnement à travers des surfaces opaques, puissance de calcul requise limitée, absence de problème d'atteinte à la vie privée, possibilité de détection de nombreux matériaux (peu de matériaux ne réfléchissent pas les ondes acoustiques), insensibilité aux perturbations électromagnétiques.

Le document de Yun, S. et al., « Strata: Fine-grained acoustic-based device-free tracking », 2017, Proceedings of the 15th Annual International Conference on Mobile Systems, Applications, and Services, pp. 15-28, décrit un algorithme permettant à un smartphone de détecter la position et la trajectoire d'un doigt sans contact avec celui-ci, en temps réel. En faisant appel aux deux microphones du smartphone, cet algorithme permet de suivre la trajectoire d'un doigt dans un plan en deux dimensions à une certaine distance du smartphone.

Cette solution présente toutefois plusieurs inconvénients : nécessité de définir au préalable une plage de distance d'interaction possible entre le doigt à détecter et le smartphone, nécessité d'avoir un mouvement du doigt, impossibilité de détecter et faire une distinction entre plusieurs doigts, solution peu robuste du fait que la détermination de la position du doigt est obtenue en réalisant une optimisation faisant intervenir le déphasage, lui-même dépendant du choix du chemin de réflexion qui dépend de la position absolue du doigt, la poursuite de trajectoire du doigt n'est possible que dans le plan en deux dimensions choisi.

Le document Etaix, N. et al., "Acoustic imaging device with one transducer", The Journal of the Acoustical Society of America 131, 2012, EL395-EL399, décrit une technique de détection utilisant un procédé de retournement temporel dans le but de faire de l'imagerie 3D. Plusieurs actionneurs piézoélectriques sont disposés sur une plaque métallique dite « chaotique » comportant des cavités percées aléatoirement dans la plaque. Un signal connu est généré par chaque actionneur et la réponse indicielle correspondante en chaque point de la surface de la plaque est mesurée avec un vibromètre. Le procédé de retournement temporel est appliqué aux signaux qui sont ensuite modifiés par une fonction mathématique. En appliquant ces nouveaux signaux aux actionneurs, des ondes acoustiques sont alors focalisées en un point choisi de l'espace. Un plan est ensuite scanné à une altitude choisie et l'écho est observé grâce à un microphone. Une fenêtre de temps qui correspond au temps théorique que mettrait un potentiel écho à revenir au microphone après une réflexion à une distance D de la plaque est choisie. En mesurant l'amplitude maximale du son dans cette fenêtre de temps, la présence ou non d'un objet à la distance D, placé aux coordonnées de focalisation choisies, est déterminée. Dans ce document, le plan se trouvant à la distance D de la plaque est scanné en focalisant les ondes acoustiques point par point puis en analysant chaque fenêtre temporelle. De plus, plusieurs plans doivent être entièrement scannés point par point pour avoir une image 3D complète de l'environnement. Il en résulte donc un temps d'acquisition très long.

## EXPOSÉ DE L'INVENTION

Un but de la présente invention est de proposer un dispositif de détection sans contact basé sur l'utilisation d'ondes acoustiques ultrasonores et ne présentant pas les inconvénients mentionnés ci-dessus, c'est-à-dire qui soit capable d'interagir via une détection de la position et/ou du mouvement d'un ou plusieurs éléments simultanément, ces éléments pouvant se trouver ou non dans des plans situés à des distances différentes du dispositif, et cela avec une courte durée d'acquisition.

Pour cela, la présente invention propose un dispositif de détection sans contact, comportant au moins :

- une surface de détection ;
- plusieurs actionneurs, par exemple piézoélectriques, couplés acoustiquement à la surface de détection et configurés pour émettre des ondes acoustiques ultrasonores ;
- un détecteur d'ondes acoustiques ultrasonores ;
- un calculateur électronique et/ou informatique ;

le dispositif étant configuré pour réaliser une détection d'un ou plusieurs éléments en mettant en œuvre plusieurs fois les étapes suivantes :

- focalisation d'ondes acoustiques ultrasonores de détection émises par les actionneurs par l'intermédiaire de la surface de détection en une région de focalisation appartenant à un plan se trouvant en regard de la surface de détection, en appliquant sur les actionneurs des signaux de commande calculés par le calculateur électronique et/ou informatique à partir d'une mesure d'une réponse impulsionnelle audio et/ou d'une réponse impulsionnelle vibratoire de la surface de détection, engendrée par une émission d'ondes acoustiques ultrasonores de calibration par chacun des actionneurs, et de l'application d'un premier procédé de retournement temporel à la réponse impulsionnelle audio et/ou à la réponse impulsionnelle vibratoire de la surface de détection, puis
- mesure d'une durée entre l'émission des ondes acoustiques ultrasonores de détection et une réception d'un écho des ondes acoustiques ultrasonores de détection par le détecteur d'ondes acoustiques ultrasonores ;

dans lequel le calculateur électronique et/ou informatique est configuré pour calculer les signaux de commande tels que les ondes acoustiques ultrasonores de détection soient focalisées successivement en des régions de focalisation de forme et/ou de dimensions différentes.

Ce dispositif propose de réaliser une détection d'un ou plusieurs éléments reposant sur l'utilisation de la focalisation acoustique obtenue grâce au principe de retournement temporel appliqué à des ondes acoustiques ultrasonores (longueurs d'onde comprises entre 16 kHz et 10 MHz) émises depuis une surface de détection, plane ou non, afin de localiser le ou les éléments, par exemple au moins un doigt ou une main d'un utilisateur, dans l'espace se trouvant devant cette surface de détection.

La détermination de la position du ou des éléments est basée sur la mesure du temps nécessaire à des ondes acoustiques focalisées pour être émises puis revenir sous la forme d'écho. L'estimation de la position du ou des éléments est réalisée en trois dimensions grâce à l'écho des ondes focalisées qui permet de définir la présence de l'élément ou d'un des éléments à détecter dans la région de focalisation qui appartient à un plan en deux dimensions, et à la mesure du délai entre l'émission des ondes et la réception de l'écho qui permet de déterminer la distance entre l'élément détecté et le détecteur d'ondes acoustiques ultrasonores qui se trouve avantageusement dans le même plan que celui dans lequel se trouve la surface de détection.

Grâce à la focalisation des ondes acoustiques ultrasonores réalisée dans plusieurs régions de focalisation différentes, plusieurs doigts peuvent être détectés indépendamment.

Cette localisation peut permettre ensuite d'enrichir les modalités d'interaction avec le dispositif, sans contact avec celui-ci.

En choisissant judicieusement les caractéristiques (dimensions et/ou formes) des régions successives de focalisation des ondes acoustiques ultrasonores, il est possible de réduire considérablement le temps d'acquisition en parcourant judicieusement différentes régions de l'espace dans lequel se trouve le ou les éléments à détecter, en faisant varier par exemple la taille des régions de focalisation et la distance atteinte par les ondes acoustiques ultrasonores focalisées, et en réalisant une poursuite de cible dynamique.

On entend par « point de focalisation » le point où les ondes acoustiques ultrasonores sont focalisées et convergent.

La détection réalisée par le dispositif peut être statique car elle n'implique pas de comparaison des signaux entre deux instants distincts. Elle peut également être quasi-statique (faible mouvement du ou des éléments à détecter) ou dynamique.

Ce dispositif peut être avantageusement utilisé pour augmenter les capacités des systèmes interactifs en allant au-delà de l'interaction tactile, pour permettre une interaction gestuelle et sans contact.

Le dispositif peut être avantageusement utilisé pour réaliser une détection de plusieurs doigts d'un utilisateur.

Ce dispositif peut permettre une interaction en temps réel d'un utilisateur.

Ce dispositif n'est pas sensible aux conditions optiques d'utilisation et est robuste vis-à-vis des perturbations électriques.

Ce dispositif est capable de réaliser une détection à une distance importante, par exemple jusqu'à environ 1 mètre de la surface de détection.

Ce dispositif a en outre pour avantage de pouvoir fonctionner avec une faible capacité de calcul électronique ou informatique car il n'utilise pas de méthode de traitement d'images pour repérer le ou les éléments à détecter. Ce dispositif récupère directement la position du ou des objets les plus proches qui ont renvoyé un écho des ondes acoustiques ultrasonores.

Ce dispositif a également pour avantage de préserver la vie privée, du fait qu'il ne réalise pas de capture d'images, qu'il fonctionne à des fréquences ultrasonores et que les données acquises sont traitées localement.

Ce dispositif peut être avantageusement utilisé pour une interaction multi-doigts à faible dynamique. En effet, le dispositif génère des sources audio virtuelles grâce à la focalisation des ondes acoustiques ultrasonores réalisée. Le nombre de sources ultrasonores virtuelles générées peut être important, ce qui augmente la précision de localisation des éléments à détecter. De plus, grâce à la focalisation réalisée, l'énergie de tous les actionneurs se retrouve concentrée dans la région de focalisation, ce qui augmente l'amplitude du signal réfléchi (écho) et simplifie donc la détection. En focalisant les ondes dans la région de focalisation, cela permet d'isoler la région étudiée vis-à-vis de toutes les réflexions parasites dont l'amplitude sera bien plus faible. La détection réalisée par le dispositif dans la région de focalisation n'est donc pas perturbée par des éléments extérieurs à cette région.

Chaque doigt peut par exemple être détecté indépendamment. De plus, même si ces doigts sont statiques, le dispositif a connaissance de la position de la région au niveau de laquelle la focalisation est réalisée. S'il reçoit une réponse, il associe une position précise au doigt détecté. L'éloignement du doigt peut être mesuré de façon encore plus précise grâce à la mesure de la durée entre l'émission des ondes acoustiques ultrasonores de détection et la réception de l'écho de ces ondes.

Le fait de focaliser les ondes acoustiques ultrasonores à partir de multiples actionneurs piézoélectriques augmente l'amplitude de l'écho reçu, ce qui facilite la détection de cet écho et la distinction de cet écho par rapport à d'éventuels échos parasites.

Ce dispositif forme donc une solution facilement intégrable et peu onéreuse permettant d'interagir avec un large espace de travail.

Les applications possibles d'un tel dispositif concernent avantageusement les interfaces de type homme - machine, ou IHM, comme par exemple les écrans interactifs fonctionnant sans contact, les tableaux de bord dans des véhicules, les interrupteurs dans le domaine du bâtiment, ou bien encore les tables interactives. Le dispositif peut également être utilisé pour des interactions sans contact avec des dispositifs informatiques, tablettes ou smartphones. Les fonctions possibles pouvant être mises en œuvre par le dispositif sont par exemple la manipulation d'objets 3D virtuels, l'utilisation d'écrans interactifs sans contact (ce qui est avantageux du point de vue sanitaire / hygiène), ou encore l'interaction avec un tableau de bord dans un espace réduit.

Ce dispositif peut également être utilisé pour d'autres types d'applications, comme par exemple dans les domaines industriels de la localisation 3D d'objets pour le contrôle robotique ou le contrôle de géométrie de pièces, ou pour des applications système telles que celles des radars de recul pour véhicule ou bien encore l'ajustement de l'orientation d'un véhicule par rapport à des cibles.

A titre d'exemple, ce dispositif peut permettre une intégration simple, compacte, et peu onéreuse de boutons de commande dans un tableau de bord d'un véhicule ou d'un équipement musical. Le dispositif proposé permet d'intégrer un nombre important de boutons et variateurs virtuels dans un espace réduit et reconfigurable formant un volume d'interaction devant le tableau de bord.

Le dispositif peut permettre d'ajouter des fonctions perceptuelles à un robot, dans le cas d'environnements difficiles (par exemple luminosité faible ou peu contrôlée, ou observation d'objets peu texturés ou transparents, ou présence de nombreuses obstructions).

Le ou les éléments détectés par le dispositif peuvent être de forme quelconque et composé de n'importe quel matériau n'absorbant pas les ondes acoustiques ultrasonores.

Dans le domaine des téléphones mobiles et de l'informatique, il est possible d'utiliser le dispositif de détection sans contact pour ajouter une dimension d'interaction, faciliter la manipulation 3D, ou encore permettre des interactions par des gestes de l'utilisateur. Des exemples d'applications du dispositif sont :

- interagir avec une application en arrière-plan (par exemple musique, appareil photo) ou activer des fonctions brèves (par exemple lampe torche, volume) ;
- interagir avec l'interface utilisateur usuelle mais sans contact (par exemple lorsque les mains dont mouillées ou sales, ou que l'appareil n'est pas à la portée de l'utilisateur) ;
- augmenter les fonctions d'interaction avec les applications (par exemple les fonctions de zoom, rotation, inclinaison, translation d'une image, les fonctions de glissé ou déposé de fichiers, les fonctions de copier ou coller d'un texte, etc.) ;
- augmenter l'interactivité de jeux vidéo.

Un smartphone ou un dispositif informatique doté d'un tel dispositif peut aussi directement être utilisé comme système de mesure 3D lors d'une activité en réalité virtuelle ou augmentée, pour scanner des objets en 3D, ou toute autre application d'imagerie 3D.

Dans le domaine automobile, le dispositif peut être utilisé pour remplacer les boutons et les écrans tactiles ou encore pour permettre d'interagir par gestuelle. Le dispositif à interaction peut être intégré directement dans le tableau de bord d'un véhicule.

Dans le domaine de la robotique industrielle, ce dispositif peut être utilisé pour permettre à un bras de robot industriel de scanner en 3D sa zone d'approche au plus près des obstacles (capteur placé sur l'effecteur) en évitant les obstructions si le capteur est centralisé.

Dans le domaine des engins de chantier/agricoles, ce dispositif peut permettre d'améliorer les fonctionnalités d'un radar de recul/approche pour prendre en compte le contexte environnant l'engin (géométrie des objets approchés pour mieux se positionner).

La calibration mise en œuvre, qui permet le calcul des signaux de commande des actionneurs pour émettre les ondes acoustiques ultrasonores de détection, peut se faire de plusieurs façons :

- mesure, à proximité ou à une certaine distance de la surface de détection, de la réponse impulsionnelle audio engendrée par l'émission des ondes acoustiques ultrasonores de calibration, puis application du premier procédé de retournement temporel à cette réponse impulsionnelle audio mesurée, et/ou
- mesure de la réponse impulsionnelle vibratoire de la surface de détection engendrée par l'émission des ondes acoustiques ultrasonores de calibration, puis application du premier procédé de retournement temporel à cette réponse impulsionnelle vibratoire mesurée.

Plus la réponse impulsionnelle audio est mesurée à proximité de la surface de détection, plus la partie rayonnante des ondes acoustiques ultrasonores de calibration est mesurée précisément (ce qui engendre moins de perte d'information), et plus la focalisation des ondes acoustiques ultrasonores de détection réalisée ensuite est précise.

La réponse impulsionnelle vibratoire de la surface de détection peut être mesurée par un vibromètre, par exemple un vibromètre laser.

Les actionneurs peuvent correspondre à des actionneurs piézoélectriques. En variante, les actionneurs peuvent être de type autre que piézoélectrique s'ils ont une réponse fréquentielle large bande, comme par exemple électrostatiques.

La surface de détection peut correspondre à une première face d'une plaque de matériau, et les actionneurs peuvent être solidarisés à une deuxième face, opposée à la première face, de la plaque de matériau. Une telle configuration permet de faciliter l'intégration du dispositif de détection, les actionneurs étant solidarisés derrière la surface à instrumenter.

La plaque formant la surface de détection peut comporter du verre et/ou du plastique et/ou du métal. Le ou les matériaux de la plaque peuvent être transparents ou non. La plaque peut être plane ou non, par exemple incurvée.

La plaque de matériau peut avoir une épaisseur comprise entre 0,1 mm et 3 mm et/ou peut comporter un matériau dont le module d'Young est compris entre 50 GPa et 300 GPa, et/ou peut être telle qu'un rapport de sa masse volumique sur le module d'Young du matériau de la plaque soit compris entre $20.10^{-8}$ kg/m.N et $50.10^{-8}$ kg/m.N. De telles caractéristiques permettent notamment de garantir une bonne transmission des ondes acoustiques ultrasonores par la plaque vers l'air.

Le détecteur d'ondes acoustiques ultrasonores peut comporter au moins un microphone et/ou des transducteurs acoustiques disposés sur la surface de détection. Les transducteurs acoustiques peuvent correspondre à des actionneurs piézoélectriques distincts des actionneurs configurés pour émettre les ondes acoustiques ultrasonores de détection.

En variante, le détecteur d'ondes acoustiques ultrasonores peut être formé par les actionneurs, par exemple piézoélectriques, configurés pour émettre les ondes acoustiques ultrasonores et qui sont aptes à réaliser en outre une transduction acoustique. Cette variante est avantageuse car elle permet une très bonne intégration du dispositif.

En outre, dans cette variante, le calculateur électronique et/ou informatique peut être configuré pour appliquer un deuxième procédé de retournement temporel à l'écho des ondes acoustiques ultrasonores de détection reçues par chacun des actionneurs. Dans ce cas, l'élément à détecter sur lequel se réfléchie l'onde focalisée est assimilé à une source sonore. Le calculateur ayant connaissance du signal émis par cette source virtuelle ainsi que de la réponse impulsionnelle liant les vibrations dans la plaque à l'ensemble des points du volume observable, peut donc, en mesurant les vibrations dans la plaque et en appliquant le principe de retournement temporel, localiser la source virtuelle. L'application de ce deuxième procédé de retournement temporel permet d'ajouter de l'information de localisation à la donnée de présence ou absence de réflecteur dans la zone de focalisation. Cette variante peut être avantageusement utilisée lorsque la taille de la tache focale acoustique, c'est-à-dire la zone où les ondes acoustiques se rejoignent, est grande lors d'une détection préliminaire, ce qui permet de choisir plus pertinemment la future zone de détection dans laquelle les ondes acoustiques seront focalisées. Cela permet donc d'améliorer la précision de localisation et la rapidité de détection du dispositif.

Les actionneurs peuvent être configurés pour émettre des ondes acoustiques ultrasonores dont les fréquences sont comprises entre 20 kHz et 100 kHz. Cette gamme de valeurs est suffisamment éloignée de la gamme des fréquences audibles par l'homme, ce qui permet d'éviter des désagréments pour l'utilisateur du dispositif.

Le calculateur électronique et/ou informatique peut être configuré pour mesurer un décalage de fréquence entre les ondes acoustiques ultrasonores de détection émises et l'écho des ondes acoustiques ultrasonores de détection, et calculer une vitesse de déplacement du ou des éléments détectés à partir du décalage de fréquence mesuré. Cette vitesse est obtenue selon la direction entre le ou les éléments détectés et le détecteur d'ondes acoustiques ultrasonores en utilisant le principe de l'effet Doppler.

Le calculateur électronique et/ou informatique peut être configuré pour coder les signaux de commande préalablement à l'émission des ondes acoustiques ultrasonores. Ce codage peut être réalisé de façon à ce que l'onde focalisée possède un contenu fréquentiel connu, une variation discrète de phase ou de fréquence, ou une modulation en fréquence. Le dispositif de détection est dans ce cas plus robuste grâce au décodage des ondes issues de l'écho, qui lui permettent de s'assurer que ce signal est bien corrélé au signal émis et qu'il n'est pas issu d'un bruit ambiant.

L'invention concerne également un dispositif à interaction sans contact, comportant au moins un dispositif de détection sans contact tel que décrit précédemment, et configuré pour réaliser une ou plusieurs actions en fonction d'un résultat de la détection réalisée par le dispositif de détection sans contact.

Le dispositif à interaction sans contact peut former une interface homme - machine comprenant une surface d'affichage à laquelle est solidarisée la surface de détection du dispositif de détection sans contact.

L'invention concerne également un procédé de commande d'un dispositif de détection sans contact tel que décrit précédemment, comportant la mise en œuvre des étapes suivantes :

- calcul, par le calculateur électronique et/ou informatique, des signaux de commande à partir d'une mesure d'une réponse impulsionnelle audio et/ou d'une réponse impulsionnelle vibratoire de la surface de détection, engendrée par une émission des ondes acoustiques ultrasonores de calibration émises par chacun des actionneurs, et de l'application d'un premier procédé de retournement temporel à la réponse impulsionnelle audio et/ou à la réponse impulsionnelle vibratoire de la surface de détection, puis

- application des signaux de commande calculés sur les actionneurs piézoélectriques, focalisant les ondes acoustiques ultrasonores de détection émises par les actionneurs piézoélectriques en une région de focalisation appartenant à un plan se trouvant en regard de la surface de détection, puis

- mesure d'une durée entre l'émission des ondes acoustiques ultrasonores de détection et une réception d'un écho des ondes acoustiques ultrasonores de détection par le détecteur d'ondes acoustiques ultrasonores ;

et dans lequel ces étapes sont répétées plusieurs fois telles que les signaux de commande calculés focalisent les ondes acoustiques ultrasonores de détection successivement en des régions de focalisation de forme et/ou de dimensions différentes.

Le procédé peut comporter en outre une calibration du dispositif de détection sans contact comportant la mise en œuvre des étapes suivantes :

- émission des ondes acoustiques ultrasonores de calibration par chacun des actionneurs piézoélectriques ;

- mesure d'une réponse impulsionnelle audio et/ou d'une réponse impulsionnelle vibratoire de la surface de détection engendrée par l'émission des ondes acoustiques ultrasonores de calibration ;

- application du premier procédé de retournement temporel à la réponse impulsionnelle audio et/ou à la réponse impulsionnelle vibratoire de la surface de détection ;
- mémorisation des signaux obtenus en appliquant le premier procédé de retournement temporel à la réponse impulsionnelle audio et/ou à la réponse impulsionnelle vibratoire de la surface de détection.

Le procédé peut avantageusement être mis en œuvre pour détecter une position ou un déplacement d'un ou plusieurs doigts d'un utilisateur du dispositif de détection.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente schématiquement un dispositif de détection sans contact selon un mode de réalisation particulier ;
- la figure 2 représente schématiquement le principe de fonctionnement du dispositif de détection sans contact selon le mode de réalisation particulier ;
- la figure 3 représente la distribution spatiale de la focalisation obtenue à différentes distances de la surface de détection du dispositif de détection sans contact, pour une même émission d'ondes acoustiques focalisées en un même point de focalisation ;
- la figure 4 représente plusieurs échos d'ondes acoustiques ultrasonores obtenus pour une même émission d'ondes, lorsque ces ondes sont réfléchies par des objets se trouvant à différentes distances ;
- la figure 5 représente un dispositif à interaction sans contact selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

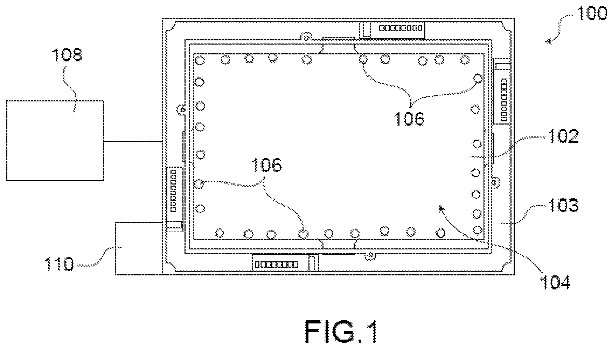

Un dispositif de détection sans contact 100 selon un mode de réalisation particulier est décrit ci-dessous en lien avec la figure 1.

Le dispositif 100 comporte une plaque de matériau 102 dont une première face 104 forme une surface de détection du dispositif 100. La plaque 102 comporte par exemple du verre, du plastique ou du métal. La plaque 102 a par exemple une épaisseur comprise entre 0,1 mm et 3 mm et/ou comporte un matériau dont le module d'Young est compris entre 50 GPa et 300 GPa et/ou est telle qu'un rapport de sa masse volumique sur le module d'Young du matériau de la plaque 102 soit compris entre $20.10^{-8}$ kg/m.N et $50.10^{-8}$ kg/m.N.

La plaque 102 est ici fixée à un cadre 103. Lorsque le dispositif 100 est destiné à être adapté en face avant d'un écran, la plaque 102 peut comporter un matériau transparent afin que l'écran reste visible à travers elle, lorsque les actionneurs piézoélectriques 106 décrits plus loin sont disposés en périphérie de la plaque 102,

Selon un exemple de réalisation particulier, les dimensions de la plaque 102 sont par exemple égales à 156 mm x 76 mm, avec une épaisseur égale à 0,5 mm.

La plaque 102 peut être plane ou non, par exemple incurvée.

Le dispositif 100 comporte également plusieurs actionneurs 106 couplés acoustiquement à la surface de détection et configurés pour émettre des ondes acoustiques ultrasonores. De manière avantageuse, les actionneurs 106 correspondent à des actionneurs piézoélectriques. En variante, les actionneurs 106 peuvent être de type électrostatique.

Dans le mode de réalisation particulier décrit ici, les actionneurs 106 sont solidarisés, par exemple par collage, à une deuxième face, opposée à la première face 104, de la plaque 102. En outre, dans le mode de réalisation particulier décrit ici, les actionneurs 106 sont solidarisés à la plaque 102 à proximité des bords de celle-ci. En variante, il est possible que les actionneurs 106 soient disposés en tout point de la deuxième face de la plaque 102. Dans une autre variante, les actionneurs 106 peuvent être disposés du côté de la première face 104 de la plaque 102, c'est-à-dire du côté de la surface de détection.

Selon un exemple de réalisation, chaque actionneur piézoélectrique 106 comporte une portion de matériau piézoélectrique, par exemple du PZT, disposée entre au moins deux électrodes de commande permettant d'appliquer une différence de potentiels sur la portion de matériau piézoélectrique. A titre d'exemple, chaque actionneur piézoélectrique 106 peut comporter une portion de PZT réalisée sous la forme d'une lamelle de dimensions égales à 70 mm x 10 mm x 0,2 mm, à laquelle sont couplées 16 électrodes destinées à actionner cette lamelle de PZT.

De manière générale, le nombre de premiers actionneurs 106 couplés acoustiquement à la surface de détection du dispositif 100 est par exemple compris entre 1 et 32, voire plus selon l'électronique d'actionnement du dispositif 100. Plus le nombre et les dimensions des actionneurs 106 sont importants, plus la puissance du signal émis par le dispositif 100 est importante, et meilleure est la résolution de focalisation obtenue.

Les actionneurs piézoélectriques 106 sont configurés pour émettre des ondes acoustiques ultrasonores dont les fréquences sont avantageusement comprises entre 20 kHz et 100 kHz.

Le dispositif 100 comporte également un calculateur électronique et/ou informatique 108, représenté symboliquement sur la figure 1 par un rectangle désigné par la référence 108. Une des fonctions de ce calculateur 108 est de calculer des signaux de commande destinés à être appliqués sur les actionneurs piézoélectriques 106.

Le dispositif 100 comporte également un détecteur d'ondes acoustiques ultrasonores 110. Ce détecteur 110 est destiné à capter l'écho des ondes acoustiques ultrasonores qui seront émises par les actionneurs piézoélectriques 106 à travers la plaque 102. Dans le mode de réalisation particulier décrit ici, le détecteur 110 comporte au moins un microphone disposé à proximité de la plaque 102.

En variante, le détecteur 110 peut correspondre à des actionneurs piézoélectriques supplémentaires distincts des actionneurs 106 et disposés sur la surface de détection du dispositif 100, du côté de la première face 104 de la plaque 102 ou de la deuxième face opposée à la première face 104. Selon une autre variante, le détecteur 110 peut être formé par les actionneurs piézoélectriques 106 qui assurent à la fois l'émission des ondes acoustiques ultrasonores et la réception de l'écho de ces ondes.

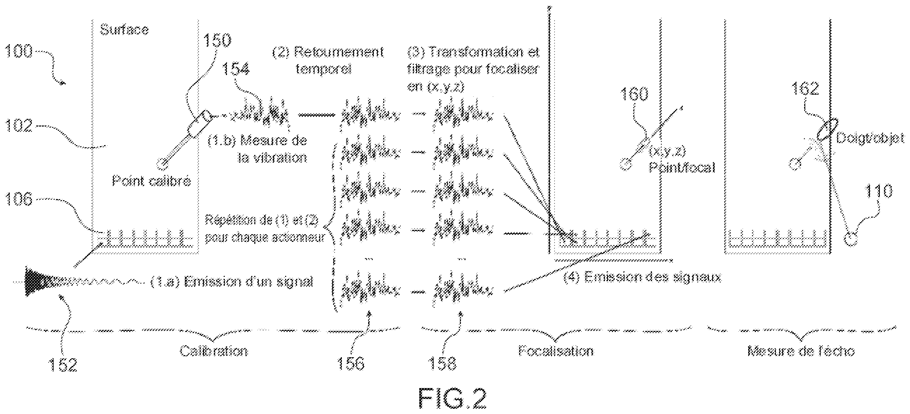

Le principe de fonctionnement du dispositif 100 est décrit ci-dessous en lien avec la figure 2.

Préalablement à la détection d'un ou plusieurs éléments par le dispositif 100, une calibration du dispositif 100 est mise en œuvre.

Pour cette calibration, selon un premier exemple de réalisation, un dispositif 150 de mesure d'ondes acoustiques ultrasonores est disposé à une distance non nulle de la surface de détection du dispositif 100. Le plan dans lequel se trouve le dispositif 150 lors de la calibration est par exemple espacé de la surface de détection d'une distance comprise entre 0 et 50 cm.

Une émission d'ondes acoustiques ultrasonores de calibration est ensuite réalisée par chacun des actionneurs 106. Ces ondes acoustiques ultrasonores de calibration correspondent par exemple à des signaux périodiques, ou pseudo-périodiques dont la fréquence instantanée varie dans au moins en partie de la gamme de fréquences utilisées pour le fonctionnement du dispositif 100. Ces signaux sont couramment appelés « chirp ». La référence 152 désigne un exemple de signal de commande pseudo-périodique appliqué sur les électrodes de commande d'un des actionneurs piézoélectriques 106.

L'onde acoustique ultrasonore de calibration émise par chacun des actionneurs piézoélectriques 106, propagée et réfléchie dans la plaque 102, est mesurée par le dispositif 150. Sur la figure 2, la référence 154 désigne symboliquement une des ondes acoustiques ultrasonores de calibration mesurées par le dispositif 150. Chacune des ondes acoustiques mesurées en un point, issues de l'émission de chacun des actionneurs piézoélectriques 106, sont enregistrées en tant que données de calibration de ce point.

Un procédé de retournement temporel est ensuite appliqué sur chacune des ondes acoustiques ultrasonores de calibration mesurées par le dispositif 150. Les signaux obtenus après l'application de ce procédé correspondent aux ondes destinées à être émises par chacun des actionneurs piézoélectriques 106 pour obtenir une focalisation de ces ondes au point de focalisation correspondant à l'emplacement du dispositif 150. Sur la figure 2, la référence 156 désignent symboliquement les signaux obtenus après application du procédé de retournement temporel. Des détails de mise en œuvre du procédé de retournement temporel sont par exemple décrits dans le document de Fink M., « Time Reversal of Ultrasonic Fields - Part I : Basic Principles », IEEE Transactions on Ultrasonics, Ferroelectrics, and Frequency Control, vol. 39, n°5, pages 555-566, Septembre 1992.

Ce procédé de calibration du retournement temporel est ensuite répété pour un grand nombre d'emplacements du dispositif 150 en regard de la plaque 102. Par exemple, dans la variante présentée en figure 2, cette calibration est répétée de manière à ce que les emplacements du dispositif 150 forment un maillage couvrant toute la surface de la première face 104 et ayant un espacement de 10 mm entre deux emplacements voisins du dispositif 150.

Les signaux obtenus après application du procédé de retournement temporel sur chacune des ondes acoustiques ultrasonores de calibration mesurées par le dispositif 150 sont ensuite mémorisés dans une mémoire ou une base de données du dispositif 100, faisant par exemple partie du calculateur 108.

Selon un deuxième exemple de réalisation, cette calibration peut être réalisée non pas en mesurant la réponse impulsionnelle audio engendrée par l'émission des ondes acoustiques ultrasonores de calibration, mais en mesurant la réponse impulsionnelle vibratoire sur la surface de détection engendrée par l'émission des ondes acoustiques ultrasonores de calibration. Dans ce cas, le dispositif 150 est remplacé par un vibromètre, par exemple de type laser, disposé contre la plaque 102 et qui permet de mesurer cette réponse impulsionnelle vibratoire.

A l'issue de cette phase de calibration, le dispositif 100 est utilisé pour réaliser une détection d'un ou plusieurs éléments cherchant par exemple à interagir avec le dispositif 100.

Pour cela, les actionneurs 106 sont commandés pour émettre simultanément des ondes acoustiques ultrasonores de détection focalisées en une région de l'espace dans laquelle la présence du ou des éléments cherchant à interagir avec le dispositif 100 est recherchée. Les signaux de commande permettant d'obtenir des focalisations des ondes acoustiques ultrasonores dans la région de focalisation souhaitée sont calculés par le calculateur 108 en appliquant une transformation et un filtrage aux signaux précédemment mémorisés à la fin de la phase de calibration, Sur la figure 2, la référence 158 désigne symboliquement les signaux de commande calculés qui permettent d'obtenir une focalisation des ondes acoustiques ultrasonores en un point de focalisation souhaité désigné par la référence 160.

Le signal émis et focalisé par les actionneurs 106 est choisi de façon à n'exciter que des fréquences ultrasonores, par exemple filtrant les fréquences inférieures à 20kHz. Il est possible de réaliser, à l'émission, un filtrage des ondes émises.

Le filtrage des signaux avant leur émission rempli plusieurs fonctions. La première est d'adapter des signaux de vibration enregistrés à la surface de la plaque 102 lors de la calibration, afin que la focalisation se produise à une distance choisie par rapport à la surface de la plaque 102. Les calculs réalisés sont par exemple issus de la résolution de l'intégrale de Kirchhoff-Helmholtz, à laquelle des simplifications peuvent être apportées. Cette intégrale détermine la pression acoustique en un point du volume lorsque la pression acoustique et la vitesse de déplacement sont connues en tous points de la plaque 102. Elle suppose également que l'environnement dans lequel fonctionne le dispositif 100 ne contient pas de source acoustique autre que la plaque 102, auquel cas les performances du système seront réduites. Les hypothèses supplémentaires prises en compte pour résoudre l'intégrale sont que les conditions limites de la plaque 102 sont connues. Les bords de la plaque 102 sont encastrés de façon rigide ou de façon souple. Dans ces deux cas, le calculateur 108 peut résoudre une intégrale simple faisant intervenir tous les signaux enregistrés lors de la calibration d'un émetteur. Ainsi, le calculateur 108 permet de déterminer la réponse impulsionnelle théorique entre cet émetteur et le point du volume étudié. En retournant temporellement ce signal théorique et en réalisant cette procédure pour tous les émetteurs, les signaux à émettre pour focaliser une onde acoustique en ce point sont connus. L'ensemble de ces calculs peuvent être réalisés en temps réel avant l'émission, ou peuvent être préenregistrés suite à la phase de calibration. Les détails relatifs à cette procédure peuvent être trouvés dans le document de Nicolas Etaix, « Imagerie acoustique à faible nombre de transducteurs au moyen d'une cavité acoustique ». Acoustique [physics.class-ph]. Université Paris-Diderot - Paris VII, 2012, Chapitre II : Rayonnement acoustique de plaque et focalisation.

Le second rôle du filtrage est de limiter les fréquences émises par le dispositif 100 dans une bande de fréquence choisie : elles doivent rester dans le domaine des ultrasons, et un filtrage passe haut peut donc être réalisé dans ce but. La bande de fréquence choisie doit aussi permettre d'ajuster la taille de la tache focale acoustique formée par les ondes émise. Un filtrage passe bas peut donc être également réalisé tel que les hautes fréquences soient éliminées pour élargir la tache focale acoustique.

Le troisième rôle du filtrage peut être d'ajouter un codage fréquentiel, ou de phase, pour que les échos mesurés puissent être bien corrélés aux signaux émis.

En réalisant une telle focalisation, l'énergie des ondes émises par les actionneurs 106 se cumule dans la région de focalisation, ce qui permet d'obtenir un signal plus puissant dans cette région.

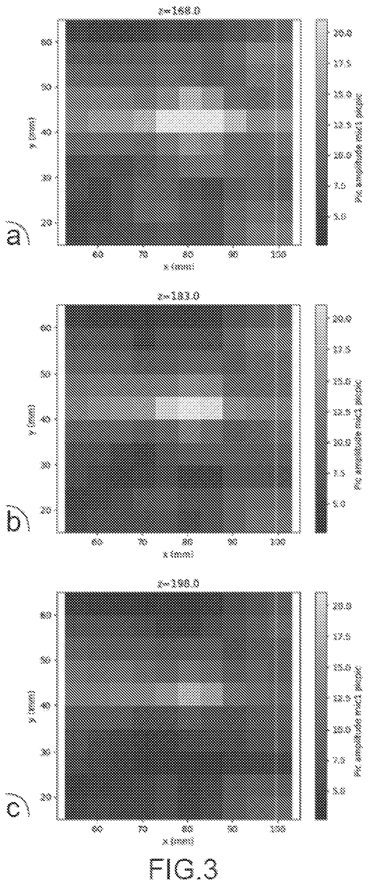

La figure 3 représente la distribution spatiale de la focalisation obtenue à différentes distances de la surface de détection pour une même émission d'ondes acoustiques focalisées en un point de focalisation se trouvant à une distance de la surface de détection égale à 183 mm. Sur les trois schémas de cette figure 3, la puissance des ondes focalisées obtenue dans un plan parallèle à la surface de détection, en fonction de la position dans ce plan, est représentée. Sur le schéma a), le plan considéré se trouve à une distance de 168 mm, tandis que sur le schéma b), le plan considéré se trouve à une distance de 183 mm (égale à la distance entre la surface de détection et le point de focalisation), et que sur le schéma c), le plan considéré se trouve à une distance de 198 mm.

Si les ondes acoustiques ultrasonores émises rencontrent un élément, désigné par la référence 162 sur la figure 2, ces ondes sont alors réfléchies sous la forme d'un écho. Cet écho est détecté par les moyens de détection 110 du dispositif 100. Le dispositif 100 réalise alors une mesure d'une durée entre l'émission des ondes acoustiques ultrasonores et la réception de l'écho de ces ondes acoustiques ultrasonores par le détecteur 110, ce qui permet de déterminer la distance entre le dispositif 100 et l'élément détecté.

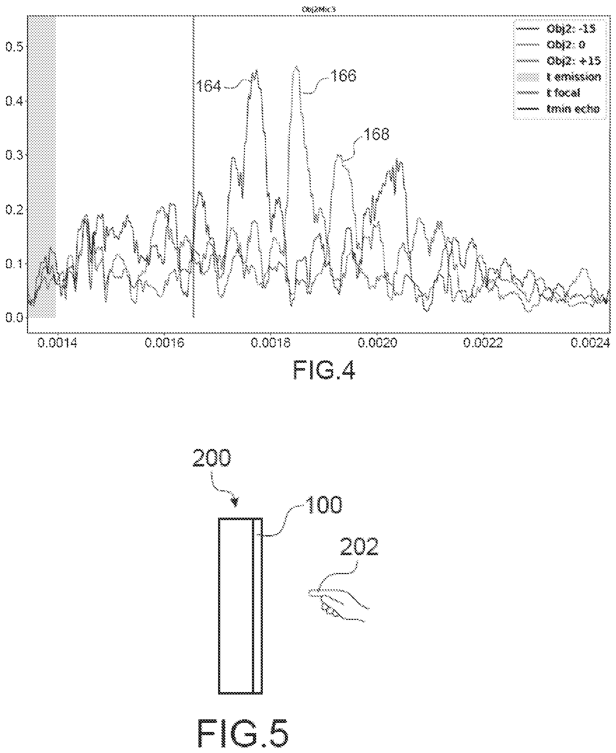

La figure 4 représente plusieurs échos d'ondes acoustiques ultrasonores obtenues pour une même émission d'ondes, lorsque ces ondes sont réfléchies par des objets de trouvant à différentes distances. La courbe 164 correspond à l'écho mesuré pour des ondes émises et focalisées en un point de focalisation distant de 200 mm de la surface de détection, et réfléchies sur un objet placé à 185 mm de la surface de détection. La courbe 166 correspond à l'écho mesuré pour des ondes émises et focalisées en un point de focalisation distant de 200 mm de la surface de détection, et réfléchies sur un objet placé à 200 mm de la surface de détection. La courbe 168 correspond à l'écho mesuré pour des ondes émises et focalisées en un point de focalisation distant de 200 mm de la surface de détection, et réfléchies sur un objet placé à 215 mm de la surface de détection.

Afin de réduire le temps de mesure de la position du ou des éléments à détecter, le calculateur 108 est configuré pour calculer les signaux de commande tels que les ondes acoustiques ultrasonores émises par les actionneurs piézoélectriques 106 soient focalisées successivement en des régions de forme et/ou de dimensions différentes. Ainsi, les dimensions et/ou la forme des régions dans lesquelles les ondes acoustiques ultrasonores sont successivement focalisées sont ajustées de manière judicieuse afin de réduire le temps nécessaire à la détection du ou des éléments à détecter.

Par exemple, il est possible de commencer la détection du ou des éléments à détecter par une vision grossière de l'environnement, c'est-à-dire en définissant une première région de focalisation relativement large, de réaliser ensuite des focalisations des ondes acoustiques émises dans une ou plusieurs régions par exemple de plus petites dimensions, pour augmenter la résolution spatiale de la mesure réalisée par le dispositif 100 et ainsi déterminer précisément la position du ou des éléments à détecter. Cela ne requiert pas une calibration supplémentaire, mais un filtrage différent sur les signaux émis afin de calculer des signaux de commande différents. Ensuite, le dispositif 100 peut réaliser des émissions d'ondes focalisées dans des régions de faibles dimensions, autour des points mesurés. En ayant déterminé au préalable la distance entre la surface de détection et l'élément détecté via la mesure de la durée de réception de l'écho des ondes, les régions de focalisation suivantes peuvent être choisies à une distance, par rapport à la surface de détection, égale à celle entre l'objet détecté et la surface de détection. Cela permet de limiter la réception d'échos parasites.

Afin d'améliorer la vitesse de détection des éléments, le dispositif 100 peut être capable de sélectionner les zones d'observation pertinentes et d'ajuster son champ d'observation selon les zones sélectionnées. Techniquement, la modification du champ d'observation peut être obtenue en élargissant plus ou moins la taille de la tache focale acoustique, c'est-à-dire en étendant plus ou moins la zone où les ondes acoustiques se rejoignent. Cela est obtenu en filtrant les hautes fréquences du signal émis par chaque actionneur 106. En effet, moins le signal émis comporte de hautes fréquences, plus la tache focale acoustique obtenue est étendue. Ainsi, même si un élément se trouve éloigné du centre de la tache focale, il renverra un écho, indiquant au dispositif 100 qu'il faut approfondir cette zone de recherche. Dans ce cas-là, la tache aura la forme d'un ellipsoïde dont le diamètre de la section horizontale est variable. Par dichotomie, en faisant varier la taille de l'ellipsoïde, le dispositif 100 peut déterminer la position précise de l'élément détecté.

Pour avoir une première image des éléments présents dans la scène observée, le dispositif 100 peut émettre des ondes de détection telles qu'elles forment plusieurs ellipsoïdes à large diamètre, à plusieurs altitudes. Comme la distance de l'élément par rapport à la surface de détection peut dans tous les cas être déterminée précisément grâce au temps de vol, cette détermination est plus rapide si la tache focale est plus allongée, tel un faisceau. Il se trouve que la technologie ne permet pas de contrôler l'allongement de ces ellipsoïdes. Néanmoins, il est possible de contrôler la distance du bas de cette géométrie par rapport à la surface d'émission, et donc de maximiser l'énergie acoustique focalisée au-dessus de ce point.

Les dimensions des taches focales choisies dépendent de la taille de l'espace à scanner, de la précision spatiale à atteindre, ainsi que du temps de réponse désiré du dispositif 100. Le diamètre à mi-hauteur d'intensité d'une tache focale tend vers la demi-longueur d'onde acoustique. Cela signifie que la fréquence utilisée par les signaux d'émission impacte directement la taille de la tache focale. Cela correspond par exemple, dans l'air, à une fréquence de 40kHz à une tache focale de 4 mm de diamètre. Néanmoins cette dimension augmente aussi avec la distance du point focal par rapport à la surface de détection, effet qui est compensé par l'ouverture d'émission équivalente du dispositif 100. Cette ouverture correspond aux dimensions de la plaque 102 auxquelles s'ajoutent une correction liée à la qualité des réflexions dans la plaque 102 et le nombre d'actionneurs 106. Ainsi, pour une plaque 102 de 150x150mm$^2$, la résolution de détection à 50 cm est théoriquement de 14 mm, cette résolution pouvant être améliorée par les conditions d'encastrement et le nombre d'actionneurs 106 du dispositif 100.

D'autre part, le choix de la fréquence avec laquelle des détections sont réalisées pour de grandes régions de focalisation dépend de l'application. Si l'action effectuée lors de l'interaction ne nécessite qu'un doigt, le dispositif 100 peut être configuré pour décider de ne poursuivre que ce doigt détecté sans procéder à des détections dans de grandes régions de focalisation.

Un travail d'algorithmique peut être mis en œuvre pour choisir la zone optimale à scanner.

Lorsque le dispositif 100 est configuré pour réaliser une détection d'un ou plusieurs éléments en mouvement, le dispositif 100 peut être configuré pour mesurer au moins un décalage de fréquence entre les ondes acoustiques de détection émises et l'écho de ces ondes, et calculer une vitesse de déplacement du ou des éléments détectés à partir du décalage de fréquence mesuré. Ainsi, grâce à la mesure de l'effet Doppler (correspondant au décalage de fréquence mesuré), il est possible de déterminer la vitesse de déplacement du ou des éléments détectés. Il est ensuite possible de déterminer d'autres informations concernant le déplacement du ou des éléments détectés, comme par exemple prédire sa distance future, par rapport à la surface de détection, après une certaine durée et anticiper les positions des points de focalisation auxquels les ondes acoustiques ultrasonores seront focalisés lors des prochaines détections. En parallèle de ces phases de suivi de déplacement, le dispositif 100 peut focaliser les ondes acoustiques ultrasonores dans des régions de focalisation larges, afin par exemple de détecter l'apparition de nouveaux éléments cherchant à interagir avec le dispositif 100.

D'autre part, la géométrie de la région de focalisation peut également être modifiée. Par exemple, il est possible de générer une sorte de rayon qui permet de détecter un objet sur une grande plage d'altitude, sans avoir à scanner chaque altitude distincte.

Pour améliorer la robustesse de l'observation et la mesure des échos, les ondes acoustiques ultrasonores focalisées peuvent être codées. Ce codage peut être réalisé en alternant la phase des signaux et/ou le contenu fréquentiel des signaux de commande appliqués sur les premiers actionneurs piézoélectriques 106. En effet, même si la focalisation des ondes réalisée par le dispositif 100 permet d'éviter que la détection réalisée soit perturbée par des obstacles plus éloignés ou se trouvant en dehors de la région de focalisation considérée, il est possible qu'une partie des ondes acoustiques ultrasonores émises soient détectées avec un certain retard par le détecteur 110, après réflexion de ces ondes hors point de focalisation. Le codage des ondes acoustiques ultrasonores émises permet de s'assurer, en comparant si l'écho reçu comporte le même codage que celui appliqué à l'émission, que les échos captés par les moyens de détection correspondent bien aux ondes initialement émises.

Dans une variante de réalisation du dispositif 100, les actionneurs piézoélectriques 106 peuvent être utilisés pour annuler ou atténuer les vibrations résiduelles de la plaque 102, afin d'accélérer le procédé de détection, ou augmenter le rapport signal sur bruit de la mesure. En effet, les vibrations dans la plaque 102 se poursuivent après l'émission du signal de focalisation, suite à de nombreuses réflexions se produisant avant que les ondes ne finissent par s'atténuer naturellement. Cet allongement involontaire du signal émis conduit aussi à un allongement du signal écho reçu, et nécessite d'attendre que le système complet soit stabilisé avant de générer une nouvelle impulsion ou d'accepter une perte de qualité du signal. Cette atténuation des vibrations de la plaque 102 évite ainsi que la nouvelle réception soit parasitée par l'ancienne.

Afin d'avoir une émission brève et contrôlée, il est possible d'atténuer de façon active les vibrations résiduelles. En effet, grâce à la calibration, la réponse de la plaque 102 suite à l'émission des signaux de focalisation est connue. Comme les actionneurs 106 couvrent une grande surface parcourue par ces ondes, il est possible de les commander avec un signal d'amplitude opposée au signal de vibration résiduelle, qui est connu en chacune de leur position. Ces signaux d'atténuation active peuvent être appliqués directement à la suite des signaux de focalisation par retournement temporel.

Selon une autre variante, ces vibrations résiduelles peuvent être éliminées numériquement grâce au fait qu'elles sont connues, car dues à l'émission d'ondes acoustiques ultrasonores calculées. Leur effet au point de focalisation est calculé numériquement. En effet, la vibration résiduelle de la plaque 102 étant connue suite à la calibration, il est possible de calculer le champ acoustique qu'elles génèrent dans le volume. Connaissant ce signal, si un objet a été détecté dans la zone de focalisation, il est possible de supprimer directement ce signal dans la mesure acoustique qui suivra la focalisation suivante. Ainsi, il est possible de réaliser une détection en un nouveau point avant que l'écho de la mesure précédente soit totalement atténué et sans que cela ne perturbe la mesure.

Ces variantes permettent de récupérer un écho des ondes acoustiques ultrasonores qui n'est pas ou peu perturbé par ces vibrations résiduelles.

Selon une variante de réalisation, lorsque les moyens de détection 110 utilisés correspondent aux actionneurs piézoélectriques 106, il est possible d'appliquer un deuxième procédé de retournement temporel aux ondes reçues, ce qui permet d'améliorer la précision de localisation du ou des éléments détectés. En effet, l'élément à détecter sur lequel se réfléchie l'onde focalisée est assimilé à une source sonore. Le calculateur 108 ayant connaissance du signal émis par cette source virtuelle ainsi que de la réponse impulsionnelle liant les vibrations dans la plaque 102 à l'ensemble des points du volume observable, peut, en mesurant les vibrations dans la plaque 102 et en appliquant le principe de retournement temporel, localiser la source virtuelle. L'application de ce deuxième procédé de retournement temporel permet d'ajouter de l'information de localisation à la donnée de présence ou absence de réflecteur dans la zone de focalisation. Cela peut être avantageusement utilisé lorsque la taille de la tache focale est grande lors d'une détection préliminaire et permet ainsi de choisir plus pertinemment la future région de focalisation. Cela peut donc améliorer la précision de localisation et la rapidité de détection du dispositif 100.

Selon une autre variante de réalisation, en complément de toutes ces techniques de localisation acoustique, les électrodes des actionneurs piézoélectriques 106 peuvent être utilisées comme capteurs capacitifs mutuels. Dans ce cas, des perturbations du champ électrique proche de la surface de détection peuvent être mesurées et associées à la présence d'un élément à détecter. Ceci augmente avantageusement la précision d'interaction en champ proche du dispositif 100.

Dans cette autre variante, les électrodes supérieures des actionneurs piézoélectriques 106 collées à la surface de détection peuvent être connectées à un système électronique de mesure capacitive par exemple formé par le calculateur 108. Celui-ci peut mesurer la capacité formée par les électrodes supérieures de deux actionneurs 106 adjacents. Lorsqu'un objet dont la permittivité électrique est différente de celle de l'air est présent, celui-ci déforme les lignes de champ électrique, et donc la capacité mutuelle entre ces électrodes. Par exemple, en présence d'un doigt, qui a une permittivité supérieure à celle de l'air, cette capacité mutuelle augmente. Cette augmentation de la capacité mutuelle dépend de la taille du doigt et de sa distance avec la surface de détection, mais en utilisant plusieurs couples d'électrodes, il est possible de retrouver ces informations et ainsi de localiser précisément le doigt, tant en distance par rapport à la surface de détection que dans le plan dans lequel il se trouve. Cette technique peut améliorer la précision d'interaction proche de la surface, mais aussi lorsque l'objet touche la surface car dans ce cas, le retournement temporel ne s'applique plus car l'objet atténue les ondes de focalisation et il n'y a pas d'écho. Néanmoins, la précision diminue très rapidement avec la distance (quelques cm) alors que ce n'est pas le cas en acoustique (jusqu'à quelques dm). Cette variante a l'avantage d'utiliser un seul système pour exploiter plusieurs principes physiques complémentaires dans le but de réaliser une détection d'interaction.

Pour toutes les variantes et exemples de réalisation précédemment décrits, le principe physique de détection acoustique ultrasonore utilisé par le dispositif 100 ne requiert pas de spécificité particulière pour former la surface de détection. Cependant, certains paramètres peuvent améliorer les performances de détection, et un compromis sur ces paramètres peut permettre de maximiser le contraste de focalisation, la résolution de focalisation et l'amplitude du signal d'écho obtenus. Ces paramètres de la plaque 102 formant la surface de détection sont : la masse surfacique $\rho_s$ et le module d'Young $Y$ associé au coefficient de poisson $v$ du matériau de la plaque 102, l'épaisseur e de la plaque 102 et la surface S de détection, le nombre Q d'actionneurs 106, la largeur de bande de fréquences utilisée $B$, la fréquence minimale des signaux $f$ et le temps d'émission T des signaux.

Un premier élément à considérer est la fréquence de coïncidence $f_c$. Celle-ci correspond au fait que la longueur d'onde acoustique dans la plaque 102 est égale à celle de l'air. A cette fréquence et légèrement au-dessus, le couplage plaque-air est maximisé, ce qui permet d'obtenir un rayonnement maximal de la plaque 102 et donc d'augmenter l'amplitude et la richesse des signaux émis pour avoir une focalisation idéale. Cette fréquence peut être choisie à 20kHz, pour avoir un bon couplage jusqu'à 100kHz. Cette fréquence de coïncidence s'exprime par la formule suivante :

$$f_c = \frac{1}{2.\pi} . c_0^2 . \sqrt{\frac{12.\rho_s.(1-v^2)}{Y.e^3}}$$, avec $c_0$ la vitesse du

son dans l'air. $Y$, $v$ et $\rho_s$ étant liés au matériau de la plaque 102, l'ajustement de l'épaisseur e de la plaque 102 est privilégié pour définir une raideur de plaque

$$D = \frac{Y.e^3}{12.(1-v^2)}$$, telle que $f_c = \frac{1}{2.\pi} . c_0^2 . \sqrt{\frac{\rho_s}{D}}$. Lorsqu'on augmente e, donc D, le couplage basse fréquence de la plaque 102 s'améliore. Mais il faut éviter que $f_c$ soit trop faible pour éviter le rayonnement dans le domaine audible.

Pour un bon contraste de focalisation $C_{idéal}$, il est préférable d'avoir de nombreux modes de vibration dans la bande de fréquence utilisée, qui sont liés à la raideur, aux fréquences et à la surface de la plaque 102. Ce contraste de focalisation s'exprime par la relation

$$C_{idéal}^2 = B . \frac{S}{2} . \sqrt{\frac{D}{\rho_s}}$$. Ainsi, en augmentant la raideur, la surface de la plaque 102 et la largeur de bande du signal émis, un contraste idéal est obtenu. Néanmoins, cela suppose que le produit $Q.T$ soit grand devant $\frac{S}{2} . \sqrt{\frac{D}{\rho_s}}$, car si ces grandeurs sont proches, C diminue.

Or, le temps d'émission T est limité par le coefficient d'atténuation de la plaque $\tau$. Au-delà d'un temps d'émission égal à $3.\tau$, l'augmentation de T n'a plus d'effet. De plus, un temps d'émission T important diminue la rapidité de détection du dispositif 100. D'autre part, le nombre d'actionneurs 106 utilisable est limité par l'électronique d'acquisition.

Compte tenu de ce qui est indiqué ci-dessus, il est préférable d'avoir une plaque 102 ayant une raideur élevée, donc une épaisseur importante. Néanmoins, la plaque 102 doit pouvoir continuer à transmettre des ondes planes. De plus, plus la plaque 102 est raide, plus l'amplitude des vibrations est faible, et le dispositif 100 se retrouve confronté à l'effet du bruit ambiant qui diminue le ratio signal sur bruit. Dans la configuration où la plaque 102 est elle-même réceptrice de l'écho, la plaque 102 n'est pas réalisée telle qu'elle soit trop raide pour que l'écho se propage à nouveau dans la plaque 102. Un compromis doit donc être réalisé sur la raideur de la plaque 102.

Enfin, il est préférable d'éviter que le matériau de la plaque 102 soit trop visqueux (comme c'est par exemple le cas du plastique) pour éviter une atténuation trop importante des signaux. L'atténuation $\tau$ ne doit pas être non plus trop faible, auquel cas les signaux continueraient à se réverbérer longtemps après l'émission. L'atténuation est contrôlée par le type de condition limite (i.e. rigide/libre/simplement supporté) et le matériau qui supporte la plaque 102. Un encastrement rigide ou libre diminue l'atténuation.

Par exemple, pour satisfaire aux contraintes exposées ci-dessus, la plaque 102 peut comporter du verre, être disposée sur de la mousse et avoir les paramètres suivants : $e = 0.7$ $mm$, $S = 80 \times 160$ $mm^2$, $Y = 60$ $GPa$, $v = 0.24$, $\rho_s = 1.62$ $kg.m^{-2}$, $T = 2$ $ms$, $B = 80$ $kHz$, $Q = 32$. Avec de tels paramètres, il est possible d'obtenir une focalisation avec les caractéristiques suivantes : $\tau = 1$ $ms$, $C_{idéal} = 23$ $SI$, $C = 22$ $SI$, $f_c = 18$ $kHz$.

La figure 5 représente schématiquement un dispositif à interaction sans contact 200 comportant un dispositif de détection sans contact 100. Le dispositif 200 est configuré pour réaliser une ou plusieurs actions en fonction d'un résultat de la détection réalisée par le dispositif 100. Sur l'exemple de la figure 5, le dispositif 200 correspond à une interface homme - machine comprenant une surface d'affichage, par exemple un écran, à laquelle est solidarisée la surface de détection du dispositif 100, et qui est destiné à interagir avec une main (un doigt 202 est représenté sur la figure 5) d'un utilisateur du dispositif 200. Par exemple, en fonction des gestes détectés par le dispositif 100, le dispositif 200 peut réaliser des affichages d'informations dont le contenu dépend des gestes détectés. Selon un autre exemple, le dispositif 200 peut servir à réaliser une manipulation d'objets virtuels 3D affichés sur un écran du dispositif 200, ces manipulations correspondant aux gestes détectés par le dispositif 100.

Selon un autre exemple de réalisation, le dispositif 200 peut correspondre à un robot auquel des fonctions perceptuelles sont implémentées par l'intermédiaire du dispositif de détection 100.

## Revendications

1. Dispositif de détection sans contact (100), comportant au moins :

   - une surface de détection ;
   - plusieurs actionneurs (106) couplés acoustiquement à la surface de détection et configurés pour émettre des ondes acoustiques ultrasonores ;
   - un détecteur d'ondes acoustiques ultrasonores (110) ;
   - un calculateur électronique et/ou informatique (108) ;
   le dispositif (100) étant configuré pour réaliser une détection d'un ou plusieurs éléments (162) en mettant en œuvre plusieurs fois les étapes suivantes :

   - focalisation d'ondes acoustiques ultrasonores de détection émises par les actionneurs (106) par l'intermédiaire de la surface de détection en une région de focalisation appartenant à un plan se trouvant en regard de la surface de détection, en appliquant sur les actionneurs (106) des signaux de commande (158) calculés par le calculateur électronique et/ou informatique (108) à partir d'une mesure d'une réponse impulsionnelle audio et/ou d'une réponse impulsionnelle vibratoire de la surface de détection, engendrée par une émission d'ondes acoustiques ultrasonores de calibration par chacun des actionneurs (106), et de l'application d'un premier procédé de retournement temporel à la réponse impulsionnelle audio et/ou à la réponse impulsionnelle vibratoire de la surface de détection, et **caractérisé par** l'étape
   - mesure d'une durée entre l'émission des ondes acoustiques ultrasonores de détection et une réception d'un écho des ondes acoustiques ultrasonores de détection par le détecteur d'ondes acoustiques ultrasonores (110) ;

   dans lequel le calculateur électronique et/ou informatique (108) est configuré pour calculer les signaux de commande (158) tels que les ondes acoustiques ultrasonores de détection soient focalisées successivement en des régions de focalisation de forme et/ou de dimensions différentes.

2. Dispositif de détection sans contact (100) selon la revendication 1, dans lequel la surface de détection correspond à une première face (104) d'une plaque de matériau (102), et dans lequel les actionneurs (106) sont solidarisés à une deuxième face, opposée à la première face (104), de la plaque de matériau (102).

3. Dispositif de détection sans contact (100) selon la revendication 2, dans lequel la plaque de matériau (102) a une épaisseur comprise entre 0,1 mm et 3 mm et/ou peut comporter un matériau dont le module d'Young est compris entre 50 GPa et 300 GPa, et/ou peut être telle qu'un rapport de sa masse volumique sur le module d'Young du matériau de la plaque soit compris entre $20.10^{-8}$ kg/m.N et $50.10^{-8}$ kg/m.N.

4. Dispositif de détection sans contact (100) selon l'une des revendications précédentes, dans lequel le détecteur d'ondes acoustiques ultrasonores (110) comporte au moins un microphone et/ou des transducteurs acoustiques disposés sur la surface de détection.

5. Dispositif de détection sans contact (100) selon l'une des revendications 1 à 3, dans lequel le détecteur d'ondes acoustiques ultrasonores (110) est formé par les actionneurs (106) configurés pour émettre les ondes acoustiques ultrasonores et qui sont aptes à réaliser en outre une transduction acoustique.

6. Dispositif de détection sans contact (100) selon la revendication 5, dans lequel le calculateur électronique et/ou informatique (108) est configuré pour appliquer un deuxième procédé de retournement temporel à l'écho des ondes acoustiques ultrasonores de détection reçues par chacun des actionneurs (106).

7. Dispositif de détection sans contact (100) selon l'une des revendications précédentes, dans lequel les actionneurs (106) sont configurés pour émettre des ondes acoustiques ultrasonores dont les fréquences sont comprises entre 20 kHz et 100 kHz.

8. Dispositif de détection sans contact (100) selon l'une des revendications précédentes, dans lequel le calculateur électronique et/ou informatique (108) est configuré pour mesurer un décalage de fréquence entre les ondes acoustiques ultrasonores de détection émises et l'écho des ondes acoustiques ultrasonores de détection, et calculer une vitesse de déplacement du ou des éléments détectés (162) à partir du décalage de fréquence mesuré.

9. Dispositif de détection sans contact (100) selon l'une des revendications précédentes, dans lequel le calculateur électronique et/ou informatique (108) est configuré pour coder les signaux de commande préalablement à l'émission des ondes acoustiques ultrasonores.

10. Dispositif à interaction sans contact (200), comportant au moins un dispositif de détection sans contact (100) selon l'une des revendications précédentes, et configuré pour réaliser une ou plusieurs actions en fonction d'un résultat de la détection réalisée par le dispositif de détection sans contact (100).

11. Dispositif à interaction sans contact (200) selon la revendication 10, formant une interface homme - machine comprenant une surface d'affichage à laquelle est solidarisée la surface de détection du dispositif de détection sans contact (100).

12. Procédé de commande d'un dispositif de détection sans contact (100) selon l'une des revendications 1 à 9, comportant la mise en œuvre des étapes suivantes :

- calcul, par le calculateur électronique et/ou informatique (108), des signaux de commande (158) à partir d'une mesure d'une réponse impulsionnelle audio et/ou d'une réponse impulsionnelle vibratoire de la surface de détection, engendrée par une émission des ondes acoustiques ultrasonores de calibration émises par chacun des actionneurs (106), et de l'application d'un premier procédé de retournement temporel à la réponse impulsionnelle audio et/ou à la réponse impulsionnelle vibratoire de la surface de détection, puis
- application des signaux de commande (158) calculés sur les actionneurs piézoélectriques (106), focalisant les ondes acoustiques ultrasonores de détection émises par les actionneurs piézoélectriques (106) en une région de focalisation appartenant à un plan se trouvant en regard de la surface de détection, et **caractérisé par** l'étape
- mesure d'une durée entre l'émission des ondes acoustiques ultrasonores de détection et une réception d'un écho des ondes acoustiques ultrasonores de détection par le détecteur d'ondes acoustiques ultrasonores (110) ;

et dans lequel ces étapes sont répétées plusieurs fois telles que les signaux de commande calculés focalisent les ondes acoustiques ultrasonores de détection successivement en des régions de focalisation de forme et/ou de dimensions différentes.

13. Procédé selon la revendication 12, comportant en outre une calibration du dispositif de détection sans contact (100) comprenant la mise en œuvre des étapes suivantes :

- émission des ondes acoustiques ultrasonores de calibration par chacun des actionneurs piézoélectriques (106) ;
- mesure d'une réponse impulsionnelle audio et/ou d'une réponse impulsionnelle vibratoire de la surface de détection engendrée par l'émission des ondes acoustiques ultrasonores de calibration ;
- application du premier procédé de retournement temporel à la réponse impulsionnelle audio et/ou à la réponse impulsionnelle vibratoire de la surface de détection (156) ;
- mémorisation des signaux obtenus en appliquant le premier procédé de retournement temporel à la réponse impulsionnelle audio et/ou à la réponse impulsionnelle vibratoire de la surface de détection (156).

14. Procédé selon l'une des revendications 12 ou 13, mis en œuvre pour détecter une position ou un déplacement d'un ou plusieurs doigts (202) d'un utilisateur du dispositif de détection sans contact (100).

**Patentansprüche**

1. Berührungslose Detektionsvorrichtung (100), mindestens umfassend:

- eine Detektionsfläche;
- mehrere Aktuatoren (106), die akustisch mit der Detektionsfläche gekoppelt und so eingerichtet sind, dass sie Ultraschallwellen aussenden;
- einen Ultraschall-Schallwellendetektor (110);
- einen elektronischen und/oder computergestützten Rechner (108);
wobei die Vorrichtung (100) so eingerichtet ist, dass sie eine Detektion eines oder mehrerer Elemente (162) durch mehrfaches Durchführen der folgenden Schritte durchführt:

- Fokussieren von von den Aktuatoren (106) über die Detektionsfläche emittierten Ultraschalldetektionswellen in eine Fokussierregion, die zu einer Ebene gehört, die sich gegenüber der Detektionsfläche befindet, durch Anwenden von Steuersignalen (158), die von dem elektronischen und/oder computergestützten Rechner (108) ausgehend von einer Messung einer Audioimpulsantwort und/oder einer Vibrationsimpulsantwort der Detektionsfläche berechnet werden, auf die Aktuatoren (106), erzeugt durch das Senden von Ultraschall-Kalibrierwellen durch jeden der Aktuatoren (106) und die Anwendung eines ersten Zeitumkehrverfahrens auf die Audioimpulsantwort und/oder die Vibrationsimpulsantwort der Detektionsfläche, und **gekennzeichnet durch** den Schritt
- Messen einer Dauer zwischen dem Senden der Ultraschalldetektionswellen und dem Empfang eines Echos der Ultraschalldetektionswellen durch den Ultraschall-Schallwellendetektor (110);

wobei der elektronische und/oder computergestützte Rechner (108) so eingerichtet ist, dass er die Steuersignale (158) so berechnet, dass die Ultraschalldetektionswellen nacheinander in Fokussierregionen unterschiedlicher Form und/oder Größe fokussiert werden.

2. Berührungslose Detektionsvorrichtung (100) nach Anspruch 1, wobei die Detektionsfläche einer ersten Seite (104) einer Materialplatte (102) entspricht und wobei die Aktuatoren (106) mit einer zweiten, der ersten Seite (104) gegenüberliegenden Seite der Materialplatte (102) verbunden sind.

3. Berührungslose Detektionsvorrichtung (100) nach Anspruch 2, wobei die Materialplatte (102) eine Dicke zwischen 0,1 mm und 3 mm aufweist und/oder ein Material umfassen kann, dessen Youngscher Modul zwischen 50 GPa und 300 GPa liegt, und/oder so sein kann, dass ein Verhältnis seiner Dichte zu dem Youngscher Modul des Materials der Platte zwischen $20\times10^{-8}$ kg/m.N und $50\times10^{-8}$ kg/m.N liegt.

4. Berührungslose Detektionsvorrichtung (100) nach einem der vorhergehenden Ansprüche, wobei der Ultraschall-Schallwellendetektor (110) mindestens ein Mikrofon und/oder akustische Wandler aufweist, die auf der Detektionsfläche angeordnet sind.

5. Berührungslose Detektionsvorrichtung (100) nach einem der Ansprüche 1 bis 3, wobei der Ultraschall-Schallwellendetektor (110) durch die Aktuatoren (106) gebildet ist, die zum Aussenden der Ultraschall-Schallwellen eingerichtet sind und ferner zur Durchführung einer akustischen Transduktion ausgelegt sind.

6. Berührungslose Detektionsvorrichtung (100) nach Anspruch 5, wobei der elektronische und/oder computergestützte Rechner (108) so eingerichtet ist, dass er auf das Echo der von jedem der Aktuatoren (106) empfangenen Ultraschalldetektionswellen ein zweites Zeitumkehrverfahren anwendet.

7. Berührungslose Detektionsvorrichtung (100) nach einem der vorhergehenden Ansprüche, wobei die Aktuatoren (106) so eingerichtet sind, dass sie Ultraschallwellen mit Frequenzen zwischen 20 kHz und 100 kHz aussenden.

8. Berührungslose Detektionsvorrichtung (100) nach einem der vorhergehenden Ansprüche, wobei der elektronische und/oder computergestützte Rechner (108) so eingerichtet ist, dass er eine Frequenzverschiebung zwischen den emittierten Ultraschalldetektionswellen und dem Echo der Ultraschalldetektionswellen misst und eine Bewegungsgeschwindigkeit des oder der detektierten Elemente (162) aus der gemessenen Frequenzverschiebung berechnet.

9. Berührungslose Detektionsvorrichtung (100) nach einem der vorhergehenden Ansprüche, wobei der elektronische und/oder computergestützte Rechner (108) so eingerichtet ist, dass er die Steuersignale vor dem Senden der Ultraschallwellen kodiert.

10. Berührungslose Interaktionsvorrichtung (200), die mindestens eine berührungslose Detektionsvorrichtung (100) nach einem der vorhergehenden Ansprüche aufweist und so eingerichtet ist, dass sie eine oder mehrere Aktionen in Abhängigkeit von einem Ergebnis der von der berührungslosen Detektionsvorrichtung (100) durchgeführten Detektion durchführt.

11. Berührungslose Interaktionsvorrichtung (200) nach Anspruch 10, die eine Mensch-Maschine-Schnittstelle bildet, die eine Anzeigefläche umfasst, mit der die Detektionsfläche der berührungslosen Detektionsvorrichtung (100) verbunden ist.

12. Verfahren zur Steuerung einer berührungslosen Detektionsvorrichtung (100) nach einem der Ansprüche 1 bis 9, die die Bereitstellung der folgenden Schritte aufweist:

    - Berechnen der Steuersignale (158) durch den elektronischen und/oder computergestützten Rechner (108) ausgehend von einer Messung einer Audioimpulsantwort und/oder einer Vibrationsimpulsantwort der Detektionsfläche, die durch das Senden der von jedem der Aktuatoren (106) gesendeten Ultraschall-Kalibrierwellen erzeugt wird, und Anwenden eines ersten Zeitumkehrverfahrens auf die Audioimpulsantwort und/oder die Vibrationsimpulsantwort der Detektionsfläche, und
- Anwenden der berechneten Steuersignale (158) an die piezoelektrischen Aktuatoren (106), wodurch die von den piezoelektrischen Aktuatoren (106) emittierten Ultraschalldetektionswellen in eine Fokussierregion fokussiert wird, die zu einer Ebene gehört, die sich gegenüber der Detektionsfläche befindet, und **gekennzeichnet durch** den Schritt
- Messen einer Dauer zwischen dem Senden der Ultraschalldetektionswellen und dem Empfang eines Echos der Ultraschalldetektionswellen durch den Ultraschall-Schallwellendetektor (110);

und wobei diese Schritte mehrmals so wiederholt werden, dass die berechneten Steuersignale die Detektions-Ultraschallwellen nacheinander in Fokussierregionen unterschiedlicher Form und/oder Größe fokussieren.

13. Verfahren nach Anspruch 12, das ferner eine Kalibrierung der berührungslosen Detektionsvorrichtung (100) aufweist, umfassend die Bereitstellung der folgenden Schritte:

- Aussenden der Ultraschall-Kalibrierwellen von jedem der piezoelektrischen Aktuatoren (106);
- Messen einer Audioimpulsantwort und/oder einer Vibrationsimpulsantwort der Detektionsfläche, die durch das Senden der Kalibrier-Ultraschallwellen erzeugt wird;
- Anwenden des ersten Zeitumkehrverfahrens auf die Audioimpulsantwort und/oder die Vibrationsimpulsantwort der Detektionsfläche (156);
- Speichern der Signale, die durch Anwenden des ersten Zeitumkehrverfahrens auf die Audioimpulsantwort und/oder die Vibrationsimpulsantwort der Detektionsfläche (156) erhalten werden.

14. Verfahren nach einem der Ansprüche 12 oder 13, das bereitgestellt wird, um eine Position oder eine Bewegung eines oder mehrerer Finger (202) eines Benutzers der berührungslosen Detektionsvorrichtung (100) zu detektieren.

## Claims

1. Contactless detection device (100), including at least:

- a detection surface;
- several actuators (106) acoustically coupled to the detection surface and configured to emit ultrasonic acoustic waves;

- an ultrasonic acoustic wave detector (110);
- an electronic and/or \IT computer (108);
the device (100) being configured to carry out a detection of one or more element(s) (162) by implementing the following steps several times:

- focusing detection ultrasonic acoustic waves emitted by the actuators (106) via the detection surface into a focusing region belonging to a plane located opposite the detection surface, by applying on the actuators (106) control signals (158) calculated by the electronic and/or IT computer (108) from a measurement of an audio impulse response and/or a vibratory impulse response of the detection surface, generated by an emission of ultrasonic calibration acoustic waves by each of the actuators (106), and the application of a first-time reversal method to the audio impulse response and/or to the vibratory impulse response of the detection surface, and **characterized by** the step of
- measuring a duration between the emission of the detection ultrasonic acoustic waves and a reception of an echo of the detection ultrasonic acoustic waves by the ultrasonic acoustic wave detector (110);

wherein the electronic and/or IT computer (108) is configured to calculate the control signals (158) such that the detection ultrasonic acoustic waves are focused successively into focusing regions with different shape and/or dimensions.

2. Contactless detection device (100) according to claim 1, wherein the detection surface corresponds to a first face (104) of a material plate (102), and wherein the actuators (106) are secured to a second face, opposite to the first face (104), of the material plate (102).

3. Contactless detection device (100) according to claim 2, wherein the material plate (102) has a thickness comprised between 0.1 mm and 3 mm and/or may include a material whose Young's modulus is comprised between 50 GPa and 300 GPa, and/or may be such that a ratio of its volumetric mass to the Young's modulus of the plate material is comprised between $20 \times 10^{-8}$ kg/m.N and $50 \times 10^{-8}$ kg/m.N.

4. Contactless detection device (100) according to one of the preceding claims, wherein the ultrasonic acoustic wave detector (110) includes at least one microphone and/or acoustic transducers disposed over the detection surface.

5. Contactless detection device (100) according to one of claims 1 to 3, wherein the ultrasonic acoustic wave detector (110) is formed by the actuators (106) configured to emit the ultrasonic acoustic waves and which are able to further carry out an acoustic transduction.

6. Contactless detection device (100) according to claim 5, wherein the electronic and/or IT computer (108) is configured to apply a second time reversal method to the echo of the detection ultrasonic acoustic waves received by each of the actuators (106).

7. Contactless detection device (100) according to one of the preceding claims, wherein the actuators (106) are configured to emit ultrasonic acoustic waves whose frequencies are comprised between 20 kHz and 100 kHz.

8. Contactless detection device (100) according to one of the preceding claims, wherein the electronic and/or IT computer (108) is configured to measure a frequency shift between the emitted detection ultrasonic acoustic waves and the echo of the detection ultrasonic acoustic waves, and calculating a speed of movement of the detected element(s) (162) from the measured frequency shift.

9. Contactless detection device (100) according to one of the preceding claims, wherein the electronic and/or IT computer (108) is configured to encode the control signals prior to the emission of the ultrasonic acoustic waves.

10. Contactless interaction device (200), comprising at least one contactless detection device (100) according to one of the preceding claims, and configured to carry out one or more action(s) according to a result of the detection carried out by the contactless detection device (100).

11. Contactless interaction device (200) according to claim 10, forming a human-machine interface comprising a display surface to which the detection surface of the contactless detection device (100) is secured.

12. Method for controlling a contactless detection device (100) according to one of claims 1 to 9, including the implementation of the following steps:

- calculating, by the electronic and/or IT computer (108), the control signals (158) from a measurement of an audio impulse response and/or a vibratory impulse response of the detection surface, generated by an emission of the calibration ultrasonic acoustic waves emitted by each of the actuators (106), and the application of a first-time reversal method to the audio impulse response and/or to the vibratory impulse response of the detection surface, then
- applying the calculated control signals (158) on the piezoelectric actuators (106), focusing the detection ultrasonic acoustic waves emitted by the piezoelectric actuators (106) into a focusing region belonging to a plane opposite the detection surface, and **characterised by** the step of
- measuring a duration between the emission of the detection ultrasonic acoustic waves and a reception of an echo of the detection ultrasonic acoustic waves by the ultrasonic acoustic wave detector (110);

and wherein these steps are repeated several times such that the calculated control signals focus the detection ultrasonic acoustic waves successively into focusing regions with different shape and/or dimensions.

13. Method according to claim 12, further including a calibration of the contactless detection device (100) comprising the implementation of the following steps:

- emitting calibration ultrasonic acoustic waves by each of the piezoelectric actuators (106);
- measuring an audio impulse response and/or a vibratory impulse response of the detection surface generated by the emission of calibration ultrasonic acoustic waves;
- applying the first-time reversal method to the audio impulse response and/or to the vibratory impulse response of the detection surface (156);
- memorising the signals obtained by applying the first-time reversal method to the audio impulse response and/or to the vibratory impulse response of the detection surface (156).

14. Method according to one of claims 12 or 13, implemented to detect a position or a movement of one or more finger(s) (202) of a user of the contactless detection device (100).

FIG.1

FIG.2

FIG.3

FIG.4

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **YUN, S. et al.** Strata: Fine-grained acoustic-based device-free tracking. *Proceedings of the 15th Annual International Conference on Mobile Systems, Applications, and Services*, 2017, 15-28
- **ETAIX, N. et al.** Acoustic imaging device with one transducer. *The Journal of the Acoustical Society of America*, 2012, vol. 131, EL395-EL399
- **FINK M**. Time Reversal of Ultrasonic Fields - Part I : Basic Principles. *IEEE Transactions on Ultrasonics, Ferroelectrics, and Frequency Control*, September 1992, vol. 39 (5), 555-566
- **NICOLAS ETAIX**. Imagerie acoustique à faible nombre de transducteurs au moyen d'une cavité acoustique. *Acoustique [physics.class-ph].*, 2012